(19) **Europäisches Patentamt**
**European Patent Office**
**Office européen des brevets**

(11) **EP 2 146 215 B1**

(12) **EUROPÄISCHE PATENTSCHRIFT**

(45) Veröffentlichungstag und Bekanntmachung des Hinweises auf die Patenterteilung:
**16.10.2013 Patentblatt 2013/42**

(51) Int Cl.:
*G01R 33/62* (2006.01)   *G01R 33/30* (2006.01)
*G01R 33/3873* (2006.01)   *G01R 33/28* (2006.01)
*G01R 33/3875* (2006.01)

(21) Anmeldenummer: **09165495.4**

(22) Anmeldetag: **15.07.2009**

(54) **Apparatur zur Durchführung von DNP-NMR Messungen mit Kompensationsanordnung, sowie Verfahren zur Auslegung der Kompensationsanordnung**

Apparatus for executing DNP-NMR measurements with compensation assembly and method for aligning the compensation assembly

Appareil d'exécution de mesures DNP-RMN doté d'un agencement de compensation et procédé de conception de l'agencement de compensation

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **18.07.2008 DE 102008033886**

(43) Veröffentlichungstag der Anmeldung:
**20.01.2010 Patentblatt 2010/03**

(73) Patentinhaber: **Bruker BioSpin AG**
**8117 Fällanden (CH)**

(72) Erfinder:
• **Bovier, Pierre-Alain**
**8050 Zürich (CH)**
• **Schauwecker, Robert**
**8004 Zürich (CH)**
• **Eckert, Daniel**
**8184 Bachenbülach (CH)**

(74) Vertreter: **Kohler Schmid Möbus**
**Patentanwälte**
**Ruppmannstraße 27**
**70565 Stuttgart (DE)**

(56) Entgegenhaltungen:
**EP-A1- 0 710 852**       **EP-A1- 1 460 445**
**EP-A2- 0 431 848**       **WO-A1-02/37132**
**WO-A1-2005/114244**      **WO-A1-2007/007022**
**US-A1- 2006 261 812**

## Beschreibung

Die Erfindung betrifft eine Apparatur zur Durchführung von DNP- NMR Messungen an einer Probe, mit einer Magnetanordnung zur Erzeugung eines Magnetfeldes in einem ersten Arbeitsvolumen, wobei die Magnetanordnung in einem zweiten Arbeitsvolumen ein Streufeld in Richtung einer Achse mit mindestens einem Magnetfeldgradienten erster Ordnung in Richtung der Achse erzeugt, wobei die Achse durch das zweite Arbeitsvolumen verläuft, mit einer Vorrichtung zum Messen von Magnetresonanz (MR)- Signalen der Probe aus dem ersten Arbeitsvolumen, mit einer DNP- Anregungsvorrichtung zur DNP- Anregung der Probe im zweiten Arbeitsvolumen und mit einer Positionierungseinrichtung zum Transferieren der Probe zwischen dem zweiten Arbeitsvolumen und dem ersten Arbeitsvolumen.

Eine solche Anordnung ist aus WO 2005/114244 A1 bekannt.

Hintergrund der Erfindung

Kernspinresonanz (NMR)- Spektroskopie ist eine kommerziell weit verbreitete Methode zur Charakterisierung der chemischen Zusammensetzung von Substanzen. Diese Methode hat aber den Nachteil, dass sie wenig sensitiv ist, weil die Polarisation der Atomkerne auch in großen Magnetfeldern nur schwach ist. Um das Verhältnis Signal zu Rauschen zu verbessern, kann entweder das Rauschen verringert oder das Signal vergrößert werden. In den letzten Jahren wurden große Anstrengungen unternommen, um das Rauschen zu unterdrücken. Zu diesem Zweck wurden gekühlte Probenköpfe entwickelt.

Zur Vergrößerung des Signals können bspw. stärkere Magnete gebaut werden. Alternativ dazu kann die so genannte DNP (Dynamic Nuclear Polarization) Methode angewandt werden. Dabei werden die im Hintergrundfeld des Magneten stark polarisierten Elektronen der Probe durch Strahlung im Mikrowellen-Bereich zu Elektronspinresonanz (EPR) angeregt. Durch Wechselwirkung der Elektronenspins mit den Atomkernen werden deren Spins ebenfalls stark polarisiert. Während die Polarisation der Atomkerne in einem Hintergrundfeld von 10 Tesla im Gleichgewicht auf Raumtemperatur typischerweise einige 10 ppm beträgt, kann sie mit DNP bis zu einigen Prozent betragen, wobei die Probe hierfür eingefroren und wieder aufgewärmt werden muss. Dabei ist es entscheidend, das NMR-Experiment auszuführen, bevor diese Polarisation verloren geht.

Grundsätzlich gibt es zwei Möglichkeiten, DNP zu betreiben: Entweder erfolgt die EPR-Vorpolarisation im NMR-Arbeitsvolumen oder die Probe wird in einem zweiten Arbeitsvolumen vorpolarisiert und anschließend in ein erstes Arbeitsvolumen zur Durchführung des NMR-Experimentes transportiert. Im ersten Fall besteht der Nachteil, dass wegen der typischerweise sehr großen Feldstärke im NMR-Arbeitsvolumen eine sehr hochfrequente Strahlung für die EPR-Anregung erforderlich ist, was technisch sehr schwierig ist. Im zweiten Fall, auf welchen sich die vorliegende Erfindung bezieht, muss ein Mechanismus vorhanden sein, der die Probe vom zweiten Arbeitsvolumen ins erste Arbeitsvolumen transportiert. Dieser Transportmechanismus muss möglichst schnell operieren, damit die Probe für das NMR-Experiment noch hinreichend polarisiert ist. Es ist also vorteilhaft, wenn sich die beiden Arbeitsvolumina möglichst nahe beieinander befinden. Im Streufeld einer NMR-Magnetanordnung gibt es in der Regel einen Bereich, wo die Feldstärke für DNP-Anregung geeignet ist.

Damit die Probe entsprechend vorpolarisiert werden kann, muss das Magnetfeld im zweiten Volumen jedoch hinreichend homogen sein. Das Streufeld eines NMR-Magneten erfüllt diese Anforderung nicht und muss deshalb noch korrigiert werden. Dieses Problem wird detailliert in WO 02/37132 A1 beschrieben. Eine Lösung zu diesem Problem wird in WO 2005/114244 A1 vorgeschlagen. Dort befinden sich ein supraleitender Magnet um das erste Arbeitsvolumen und ein weiterer supraleitender Magnet um das zweite Arbeitsvolumen. Der weitere Magnet hat einerseits die Aufgabe, das Felds im zweiten Arbeitsvolumen zu homogenisieren, andererseits darf er die Homogenität im ersten Arbeitsvolumen nicht verschlechtern.

Ein wesentlicher Nachteil der Anordnung nach WO 2005/114244 A1 besteht darin, dass ein konventionelles NMR-Magnetsystem auf diese Weise nicht nachgerüstet werden kann und daher das gesamte DNP-NMR-Magnetsystem neu entwickelt werden muss. Falls es sich um eine supraleitende Magnetanordnung handelt, muss im Normfall auch der Kryostat angepasst werden.

Darüber hinaus ist auch der gegenseitige Einfluss der beiden Magnete problematisch. Insbesondere kann die magnetische Kraft zwischen den Magneten so groß werden, dass der weitere Magnet um das zweite Arbeitsvolumen abgeschirmt werden muss. Dies ist sowohl aktiv mit dem Einsatz von supraleitenden Spulen wie auch passiv mit Hilfe von ferromagnetischem Material möglich, wie in WO 2005/114244 A1 beschrieben. Andererseits darf die Feldhomogenität in jedem Arbeitsvolumen nicht zu stark vom anderen Magneten beeinflusst werden. All diese Bedingungen können zu komplizierten Spulenkonfigurationen führen.

Aufgabe der Erfindung

Aufgabe der vorliegenden Erfindung ist es demgegenüber, eine Apparatur mit einem zweiten Arbeitsvolumen für DNP-NMR Anregung vorzuschlagen, bei der die Homogenisierung des Magnetfelds im zweiten Arbeitsvolumen mit technisch einfachen Mitteln bewirkt wird, so dass die Apparatur auch durch Nachrüsten einer aus dem Stand der Technik bekannten NMR-Magnetanordnung erhalten werden kann.

Kurze Beschreibung der Erfindung

Diese Aufgabe wird erfindungsgemäß dadurch gelöst, dass beim zweiten Arbeitsvolumen eine Kompensationsanordnung aus magnetischem Material angebracht ist, welche im Betriebszustand der Magnetanordnung mindestens einen Magnetfeldgradienten erster oder höherer Ordnung in Richtung der Achse im zweiten Arbeitsvolumen erzeugt, der zwischen -90% und -110% des Magnetfeldgradienten gleicher Ordnung des Streufelds der Magnetanordnung in Richtung der Achse im zweiten Arbeitsvolumen beträgt.

Dieser/diese Gradient/Gradienten ist/sind in der Überlagerung des Streufelds der Magnetanordnung mit dem Feld der Kompensationsanordnung im zweiten Arbeitsvolumen somit um mindestens einen Faktor 10 kleiner als der/die Gradient/Gradienten des Streufelds der Magnetanordnung allein. Die Kompensationsanordnung erzeugt also zusammen mit der Magnetanordnung im Bereich des zweiten Arbeitsvolumens ein Magnetfeldplateau (homogenes Feld), was für eine Vorpolarisation der Probe mittels DNP notwendig ist. Die Rolle der Kompensationsanordnung ist im Wesentlichen eine Verbesserung der Homogenität im zweiten Arbeitsvolumen. Der wesentliche Beitrag zur Stärke des Magnetfeldes im zweiten Arbeitsvolumen wird aber durch die Magnetanordnung gegeben, was eine kompakte Dimensionierung der Kompensationsanordnung ermöglicht.

Im Gegensatz zu den beiden aus WO 2005/114244 A1 bekannten Abschirmmethoden, die sich auf Methoden zur Streufeldabschirmung von zwei nahe beieinander platzierten Magnetspulen beziehen, kompensiert das magnetische Material in der vorliegenden Erfindung lediglich einen oder mehrere Feldgradienten im zweiten Arbeitsvolumen, der/die durch die um das erste Arbeitsvolumen angeordnete Magnetanordnung am Ort des zweiten Arbeitsvolumens erzeugt wird/werden. Auf diese Weise kann auf das in WO 2005/114244 A1 notwendige weitere Spulensystem beim zweiten Arbeitsvolumen prinzipiell verzichtet werden. Dies ist insbesondere hinsichtlich der einfachen Nachrüstung für bereits bestehende NMR-Systeme besonders vorteilhaft.

Bevorzugte Ausführungsform der Erfindung

Vorzugsweise umfasst die Kompensationsanordnung weichmagnetische Abschnitte, welche im Betriebszustand der Magnetanordnung vom Feld der Magnetanordnung magnetisiert werden. Weichmagnetisches Material hat die günstige Eigenschaft, dass es schon in tiefen Magnetfeldern stark magnetisiert wird, so dass die Kompensationsanordnung kompakt dimensioniert werden kann. Als weichmagnetisches Material kann beispielsweise magnetischer Stahl verwendet werden, sofern das Hintergrundfeld stark genug ist. Dies ist zum einen eine besonders billige Lösung, zum anderen weist magnetischer Stahl in der Regel eine hohe Sättigungsmagnetisierung auf. Für Anwendungen in niedrigerem Feld sind Materialien mit höherer Permeabilität vorteilhaft, wie zum Beispiel die Eisen- Nickel- Legierung FeNi48 (Nifemax®), um sicher zu gehen, dass das Material hinreichend magnetisiert wird und somit eine maximale Feldeffizienz aufweist.

Die Sättigungsmagnetisierung der weichmagnetischen Abschnitte beträgt vorzugsweise mindestens $10^6$ A/m, was eine kompakte Dimensionierung der Kompensationsanordnung erlaubt.

Besonders vorteilhaft ist es, wenn der Abstand zwischen dem Schwerpunkt des ersten Arbeitsvolumens und dem Schwerpunkt des zweiten Arbeitsvolumens größer ist als der Abstand zwischen dem Schwerpunkt des ersten Arbeitsvolumens und dem Schwerpunkt der Gesamtheit der weichmagnetischen Abschnitte. Zur Erzeugung eines Magnetfeldplateaus im zweiten Arbeitsvolumen wird demnach das weichmagnetische Abschirmmaterial der Kompensationsanordnung vorzugsweise mehrheitlich in einem Bereich zwischen dem ersten und dem zweiten Arbeitsvolumen angebracht, wo das Streufeld der Magnetanordnung stärker ist als in größerer Entfernung vom ersten Arbeitsvolumen. Im Prinzip können auch Permanentmagnete zur Verstärkung des Magnetfeldgradienten der Kompensationsanordnung verwendet werden, wobei je nach Richtung ihrer Magnetisierung eine Position zwischen dem ersten und dem zweiten Arbeitsvolumen oder aber auch eine andere Position vorteilhaft sein kann.

Falls es sich bei der Magnetanordnung zum Beispiel um eine Helmholtz-Anordnung handelt, kann sich das zweite Arbeitsvolumen beispielsweise in der Ebene zwischen den Spulenpaaren befinden, so dass die Achse im zweiten Arbeitsvolumen senkrecht zur Verbindungslinie zwischen dem Schwerpunkt des ersten und dem Schwerpunkt des zweiten Arbeitsvolumens ausgerichtet ist. Demgegenüber müssen beispielsweise bei einer solenoidförmigen Magnetanordnung beide Arbeitsvolumina auf der Solenoid-Achse liegen, damit ein Probentransport zwischen beiden Arbeitsvolumina möglich ist. In einer solenoidförmigen Magnetanordnung liegt daher der Schwerpunkt des ersten Arbeitsvolumens und der Schwerpunkt des zweiten Arbeitsvolumens auf der Achse durch das zweite Arbeitsvolumen. Diese Anordnung ist besonders vorteilhaft, weil die am meisten verbreiteten NMR-Magnetanordnungen mit solenoidförmigen Magnetspulen ausgerüstet sind.

In einer solchen Apparatur ist es besonders vorteilhaft, wenn die Kompensationsanordnung bezüglich der Achse rotationssymmetrisch ist, weil so die Symmetrie der Magnetanordnung und der Kompensationsanordnung übereinstimmen, wodurch die Auslegung der Kompensationsanordnung vereinfacht wird.

Bei einer besonderen Weiterbildung einer solchen Apparatur weisen die weichmagnetischen Abschnitte einen gemeinsamen Innen- oder Außendurchmesser auf, wobei die Wandstärke dieser Abschnitte in Richtung der Achse mit zunehmendem Abstand vom ersten Arbeitsvolumen abnimmt oder gleich bleibt. Das Streufeld der Magnetanordnung nimmt in der Regel in Richtung des ersten Arbeitsvolumens zu, so dass es für die Formung eines Feldplateaus im zweiten Arbeitsvolumen von Vorteil ist, wenn auch die Stärke des magnetischen Materials der Kompensationsanordnung in dieser Richtung zunimmt. Durch den gemeinsamen Innen- oder Außendurchmesser kann die Kompensationsanordnung auf einfache Weise gehalten werden.

Bei einer besonders bevorzugten Ausführungsform der erfindungsgemäßen Apparatur ist die Magnetanordnung mindestens teilweise supraleitend und befindet sich mindestens teilweise in einem Kryostaten, der eine Bohrung aufweist, in welcher das erste Arbeitsvolumen und das zweite Arbeitsvolumen angeordnet sind. Supraleitende Magnetanordnungen haben den großen Vorteil, dass sie sehr starke Magnetfelder erzeugen können.

Eine spezielle Weiterbildung dieser Ausführungsform sieht vor, dass die Kompensationsanordnung mindestens teilweise in der Bohrung des Kryostaten angeordnet ist. Wenn die Kompensationsanordnung komplett im Raumtemperaturzugang zum ersten Arbeitsvolumen angeordnet ist, kann diese montiert, demontiert und verändert werden, ohne dass der Kryostat aufgewärmt und geöffnet werden muss.

Alternativ hierzu kann die Kompensationsanordnung jedoch auch außerhalb der Bohrung des Kryostaten angeordnet sein, insbesondere in einem Bereich des Kryostaten mit einer Temperatur unterhalb der Raumtemperatur, vorzugsweise in einem Bereich des Kryostaten mit der Betriebstemperatur der supraleitenden Teile der Magnetanordnung. Dies ist bspw. dann interessant, wenn der Platz im Raumtemperaturzugang für die Kompensationsanordnung nicht ausreicht. Ein weiterer Vorteil ist die Temperaturstabilität der Kompensationsanordnung, weil dann auch deren Magnetisierung und deren räumliche Position relativ zur Magnetanordnung zeitlich stabil bleiben, so dass im zweiten Arbeitsvolumen ein zeitlich sehr stabiles Feld resultiert.

Es ist bevorzugt, dass die Achse der Bohrung des Kryostaten mit der Achse im zweiten Arbeitsvolumen zusammenfällt, weil dann einfachere, insbesondere axialsymmetrische, Kompensationsanordnungen möglich werden.

Vorzugsweise beträgt der Abstand zwischen dem Schwerpunkt des ersten Arbeitsvolumens und dem Schwerpunkt des zweiten Arbeitsvolumens weniger als 1 Meter. Somit bleibt die Zeit zum Transferieren der Probe vom zweiten Arbeitsvolumen ins erste Arbeitsvolumen klein, so dass auch der Verlust an Vorpolarisation der Probe klein bleibt.

Im Betriebszustand der Magnetanordnung beträgt der Absolutbetrag der Magnetfeldstärke auf der Strecke zwischen dem Schwerpunkt des ersten Arbeitsvolumens und dem Schwerpunkt des zweiten Arbeitsvolumens vorzugsweise überall mindestens die Hälfte des Absolutbetrags der Magnetfeldstärke im zweiten Arbeitsvolumen. Ein Durchgang der Probe durch ein kleineres Magnetfeld während dem Transferieren hätte unter Umständen einen unerwünschten Polarisationsverlust der Probe zur Folge.

Wenn die Magnetanordnung eine Spulenanordnung umfasst, welche das Dipolmoment der Magnetanordnung mindestens teilweise kompensiert, kann der Abstand zwischen dem ersten und dem zweiten Arbeitsvolumen verkleinert werden, was kürzere Transferzeiten und somit einen kleineren Verlust an Vorpolarisation der Probe ermöglicht.

Bei einer speziellen Ausführungsform ist eine weitere Spulenanordnung vorhanden, welche mit Strom gespeist werden kann und im zweiten Arbeitsvolumen einen homogenen Magnetfeldbeitrag und/oder einen Magnetfeldgradienten erster oder höherer Ordnung in Richtung der Achse erzeugt. Diese weitere Spulenanordnung übernimmt somit die Aufgabe einer Shimspule, um einen Restgradienten, der durch ev. Imperfektionen der Kompensationsanordnung bedingt sein kann, zu korrigieren. Dadurch kann die Feldhomogenität im zweiten Arbeitsvolumen noch weiter verbessert werden.

Eine besonders einfache Weiterbildung dieser Ausführungsform ergibt sich, wenn die weitere Spulenanordnung normalleitend ist, insbesondere wenn sich die weitere Spulenanordnung mindestens teilweise in der Bohrung des Kryostaten der supraleitenden Magnetanordnung befindet, wobei die Magnetanordnung vorzugsweise auch supraleitend ist.

Alternativ ist es jedoch auch möglich, eine Apparatur vorzusehen, bei der sowohl die Magnetanordnung als auch die weitere Spulenanordnung supraleitend ist, wobei die Magnetanordnung vorzugsweise auch supraleitend ist. Die weitere Spulenanordnung ist dann vorteilhafterweise im Kryostaten der supraleitenden Magnetanordnung angeordnet.

Bei einer besonders bevorzugten Ausführungsform ist eine Vorrichtung zum Verschieben der Kompensationsanordnung oder von Abschnitten der Kompensationsanordnung und zum Verschieben des zweiten Arbeitsvolumens entlang der Achse vorgesehen. Hierdurch kann die Kompensationsanordnung derart platziert werden, dass in der Überlagerung des Feldbeitrages der Kompensationsanordnung mit dem Feldbeitrag der Magnetanordnung der Absolutbetrag mindestens eines Magnetfeldgradienten erster oder höherer Ordnung in Richtung der Achse im zweiten Arbeitsvolumen minimal ist, insbesondere kleiner als 10% des Absolutbetrages des Magnetfeldgradienten gleicher Ordnung des Streufelds der Magnetanordnung.

Die Erfindung betrifft auch ein Verfahren zur Auslegung einer Kompensationsanordnung von magnetischem Material in einer zuvor beschriebenen Apparatur, welches dadurch gekennzeichnet ist, dass im zweiten Arbeitsvolumen in Richtung der Achse mindestens eine Messung des Magnetfeldprofils durchgeführt wird, welches aus der Überlagerung des Feldbeitrages der Kompensationsanordnung mit dem Feldbeitrag der Magnetanordnung resultiert, und dass aufgrund der Messung die Kompensationsanordnung mindestens einmal dahingehend verändert wird, dass in der Überlagerung des Feldbeitrages der Kompensationsanordnung mit dem Feldbeitrag der Magnetanordnung der Absolutbetrag mindestens eines Magnetfeldgradienten erster oder höherer Ordnung in Richtung der Achse im zweiten Arbeitsvolumen verkleinert wird.

Die einfachsten Varianten für den Verfahrensschritt der Veränderung der Kompensationsanordnung sind die Anbringung oder Entfernung von magnetischem Material, insbesondere die Anbringung von magnetischen Folien.

Eine weitere vorteilhafte Verbesserung der Feldhomogenität im zweiten Arbeitsvolumen erlaubt ein Verfahren zur Positionierung der Kompensationsanordnung und des zweiten Arbeitsvolumens, welches dadurch gekennzeichnet ist, dass im zweiten Arbeitsvolumen in Richtung der Achse mindestens eine Messung des Magnetfeldprofils durchgeführt wird, welches aus der Überlagerung des Feldbeitrages der Kompensationsanordnung mit dem Feldbeitrag der Magnetanordnung resultiert, und dass aufgrund der Messung die Kompensationsanordnung oder Abschnitte der Kompensationsanordnung zusammen mit dem zweiten Arbeitsvolumen entlang der Achse verschoben werden, so dass in der Überlagerung des Feldbeitrages der Kompensationsanordnung mit dem Feldbeitrag der Magnetanordnung der Absolutbetrag mindestens eines Magnetfeldgradienten erster oder höherer Ordnung in Richtung der Achse im zweiten Arbeitsvolumen verkleinert wird.

Die Auslegung und/oder Optimierung der erfindungsgemäßen Kompensationsanordnung erfolgt demnach gemäß den beschriebenen Verfahrensvarianten durch Verändern des magnetischen Materials der Kompensationsanordnung und/oder durch Verschiebung der Kompensationsanordnung entlang der Achse, welche durch den Feldvektor des Streufelds der Magnetanordnung am Ort des zweiten Arbeitsvolumens festgelegt ist. Das Ausmaß der Veränderung und/oder der Verschiebung des magnetischen Materials hängt ab vom Grad und von der Stärke des/der zu minimierenden Feldgradienten entlang der Achse im zweiten Arbeitsvolumen, welche/welcher aus einer Messung des Feldprofils der Überlagerung des Feldbeitrages der Kompensationsanordnung mit dem Feldbeitrag der Magnetanordnung bestimmt wird/werden. Es kann auch vorteilhaft sein, mindestens einen dieser Verfahrensschritte zu wiederholen, so dass eine weitere Veränderung und/oder Verschiebung der Kompensationsanordnung vorgenommen werden kann. Im Normalfall stellt die Veränderung und/oder Verschiebung der Kompensationsanordnung jedoch eine Feinkorrektur der Magnetfeldgradienten dar, mit der auf einfache Weise innerhalb des zweiten Arbeitsvolumens ein für eine DNP-Anregung hinreichend homogenes Magnetfeld erzeugt werden kann, ohne dass beispielsweise fertigungsbedingte Ungenauigkeiten der Magnetanordnung oder der Kompensationsanordnung durch eine aufwändigere Nacharbeit korrigiert werden müssen. Insbesondere kann ein Magnetfeldgradient im zweiten Arbeitsvolumen realisiert werden, der kleiner als 10% des Absolutbetrages des Magnetfeldgradienten gleicher Ordnung des Streufelds der Magnetanordnung ist.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Es zeigen:

Fig. 1 eine erste Ausführungsform einer erfindungsgemäßen Apparatur zur DNP-NMR Messung einer Probe mit einer Kompensationsanordnung;

Fig. 2 eine weitere Ausführungsform der erfindungsgemäßen Apparatur mit einem Kryostaten, wobei die Kompensationsanordnung in der Bohrung des Kryostaten angeordnet ist;

Fig. 3 eine weitere Ausführungsform der erfindungsgemäßen Apparatur mit einem Kryostaten, wobei die Kompensationsanordnung im Kryostaten angeordnet ist;

Fig. 4 eine Schnittdarstellung einer radialen Hälfte einer speziellen Ausführungsform der erfindungsgemäßen Kompensationsanordnung mit einem gemeinsamen Außendurchmesser aller Bestandteile der Kompensationsanordnung;

Fig. 5 die Überlagerung der Felder der Magnetanordnung und der Kompensationsanordnung aus Fig. 4 auf der Achse des zweiten Arbeitsvolumen;

Fig. 6 eine Schnittdarstellung einer radialen Flälfte einer weiteren speziellen Ausführungsform der erfindungsgemäßen Kompensationsanordnung mit einem gemeinsamen Innendurchmesser aller Bestandteile der Kompensationsanordnung;

Fig. 7 die Überlagerung der Felder der Magnetanordnung und der Kompensationsanordnung aus Fig. 6 auf der Achse des zweiten Arbeitsvolumens;

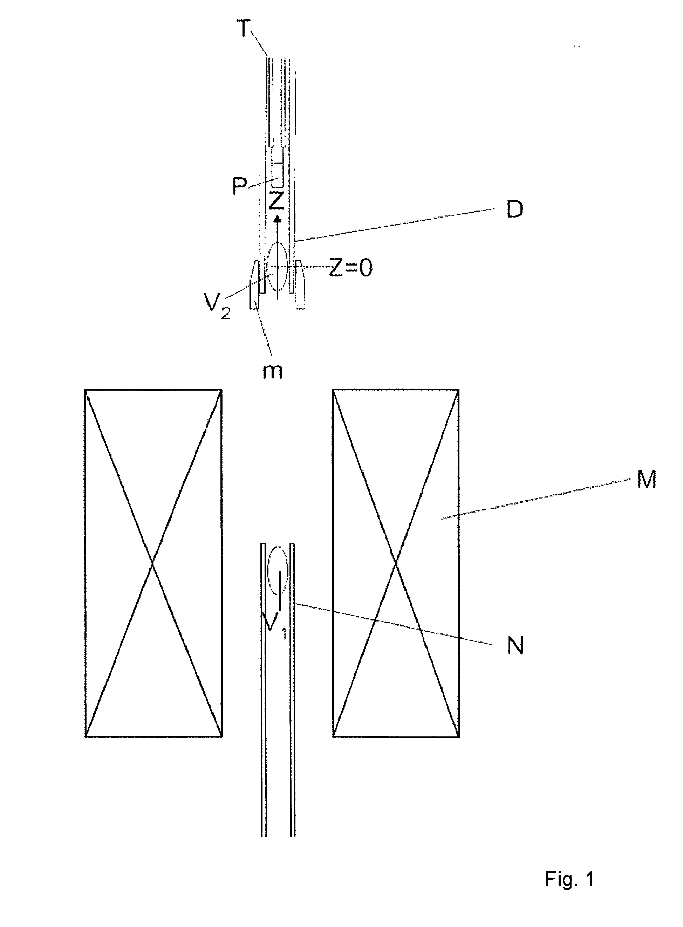

**Fig. 1** zeigt eine Apparatur zur DNP-NMR Messung einer Probe **P.** Die NMR-Messung findet in einem ersten Arbeitsvolumen **V1** statt, welches von einer Magnetanordnung **M** umgeben ist. Die Magnetanordnung M erzeugt innerhalb des Arbeitsvolumens V1 ein homogenes Magnetfeld (HO-Feld) und in einem zweiten Arbeitsvolumen **V2** ein Streufeld in Richtung einer Achse (**z**-Achse) mit einem Magnetfeldgradienten **H1M** und/oder mit Feldgradienten höherer Ordnung (**H2M, H3M, ...**) in dieser Richtung. Um das erste Arbeitsvolumen V1 ist eine Vorrichtung **N** zur NMR-Messung (Probenkopf) angeordnet. Die Probe P kann mittels eines Transportmechanismus **T** zwischen dem ersten Arbeitsvolumen V1 und dem zweiten Arbeitsvolumen V2 bewegt werden. Beim zweiten Arbeitsvolumen V2 sind eine Kompensationsanordnung m aus magnetischem Material, sowie eine Vorrichtung **D** zur DNP-Anregung angebracht. Die Kompensationsanordnung m ist in einem begrenzten axialen Bereich um die z-Achse angeordnet. Im vorliegenden Fall umgibt die Kompensationsanordnung m das zweite Arbeitsvolumen teilweise. Die Erfindung umfasst jedoch auch Apparaturen, bei denen die Kompensationsanordnung axial außerhalb des zweiten Arbeitsvolumens V2 angeordnet ist, vorzugsweise zwischen dem ersten Arbeitsvolumen V1 und dem zweiten Arbeitsvolumen V2. Ebenso ist es denkbar, dass das zweite Arbeitsvolumen V2 vollständig von der Kompensationsanordnung m umgeben ist. Die Arbeitsvolumina V1, V2 sind entweder durch die Probe P selbst oder durch die Vorrichtung N zur NMR-Messung bzw. durch die Vorrichtung D zur DNP-Anregung definiert, wobei z=0 den Mittelpunkt des zweiten Arbeitsvolumens V2 darstellt.

Fig. 1 zeigt eine besonders bevorzugte Ausführungsform, bei der die z-Achse sowohl mit der Richtung des H0-Feldes der Magnetanordnung M, als auch mit der Richtung, in der die Probe P mittels der Transportvorrichtung T transportiert werden kann, zusammenfällt. Es sind jedoch auch andere Ausführungsformen denkbar. In jedem Fall ist die z-Achse durch den Feldvektor des Streufelds, das durch die Magnetanordnung M am Ort des zweiten Arbeitsvolumens V2 bewirkt wird, festgelegt.

Zur Durchführung einer DNP-NMR-Messung wird die Probe P zunächst im zweiten Arbeitsvolumen V2 platziert und dort mittels der DNP-Vorrichtung D vorpolarisiert. Möglichst zeitnah wird die Probe P dann mittels des Transportmechanismus T vom zweiten Arbeitsvolumen V2 in das erste Arbeitsvolumen V1 bewegt. Dort erfolgt durch die NMR-Vorrichtung N die eigentliche NMR-Messung. Damit die Probe P bei Durchführung des NMR-Experiments noch genügend polarisiert ist, sind die Arbeitsvolumina V1, V2 möglichst nahe beieinander angeordnet. Die im zweiten Arbeitsvolumen V2 auftretenden, für die DNP-Vorpolarisierung unerwünschten Magnetfeldgradienten H1 M, H2M, H3M, ... des Streufeldes der Magnetanordnung M an diesem Ort werden erfindungsgemäß durch die Kompensationsanordnung m eliminiert.

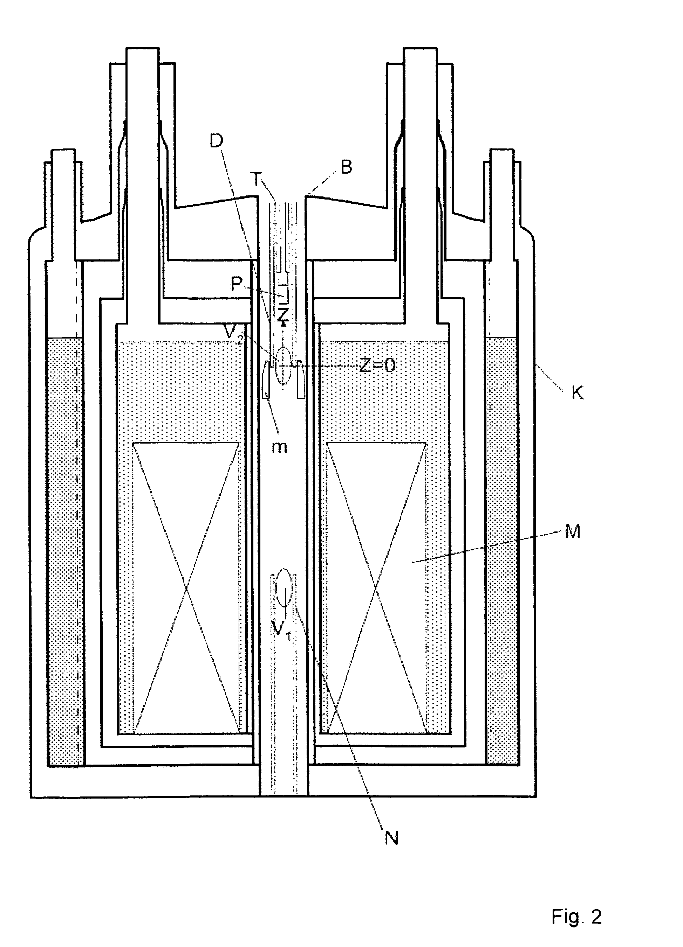

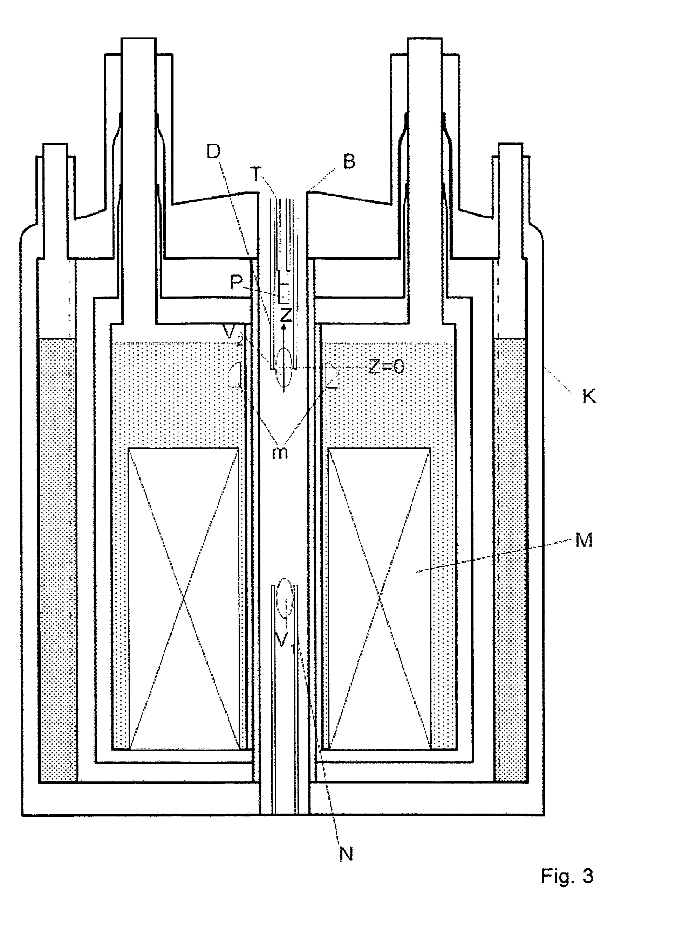

Grundsätzlich kann die erfindungsgemäße Apparatur sowohl mit einer supraleitenden als auch mit einer nicht supraleitenden Magnetanordnung betrieben werden. Bei Verwendung einer supraleitenden Magnetanordnung M ist diese innerhalb eines Kryobehälters **K** mit einer Bohrung **B** (Raumtemperaturbohrung) angeordnet, wie in Fig. 2 und 3 gezeigt. Bei der in **Fig. 2** dargestellten Ausführungsform der erfindungsgemäßen Apparatur sind das erste Arbeitsvolumen V1, das zweite Arbeitsvolumen V2, die Vorrichtung N zur NMR-Messung, die Kompensationsanordnung m, sowie die Vorrichtung D zur DNP Anregung koaxial innerhalb der Bohrung B angeordnet, die einen Raumtemperaturzugang zum ersten und zweiten Arbeitsvolumen V1, V2 bildet.

Wenn der Platz innerhalb der Bohrung B des Kryostaten K jedoch nicht ausreicht, können gewisse Teile der Apparatur auch innerhalb des Kryostaten K angeordnet werden, was im Normalfall ohne eine Vergrößerung des Kryostaten K möglich ist. Dies ist in **Fig. 3** für die die Kompensationsanordnung m gezeigt.

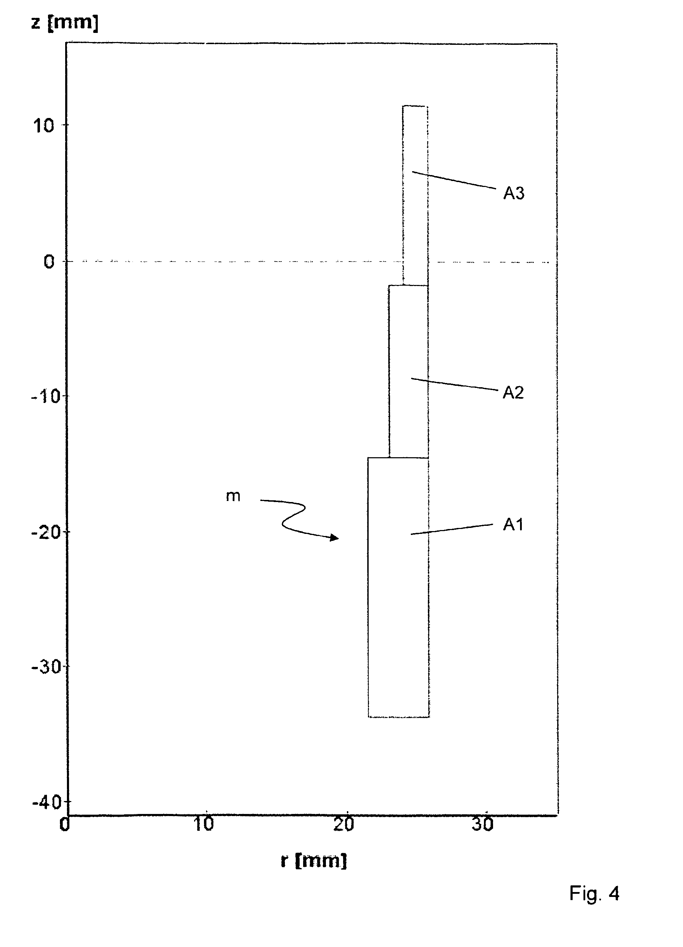

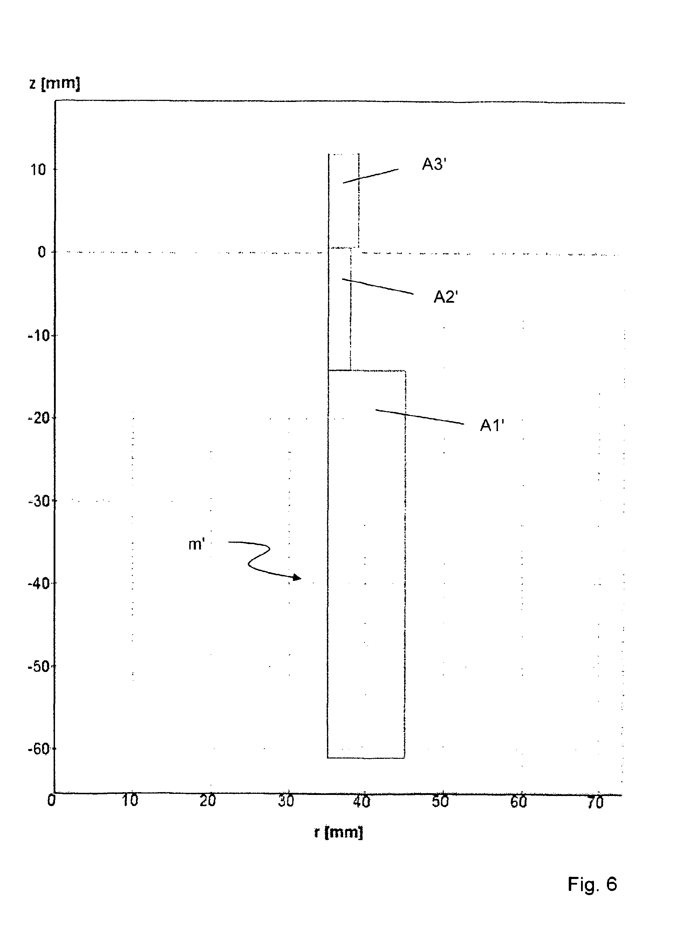

**Fig. 4, 6** zeigen Detaildarstellungen jeweils einer radialen Hälfte zweier Ausführungsformen der erfindungsgemäßen Kompensationsanordnung m, m'. Die Erfindung soll nun anhand der in Fig. 4, 6 gezeigten Beispiele von Kompensationsanordnungen m, m' aus weichmagnetischem Material erläutert werden:

Die Magnetanordnung M erzeugt im zweiten Arbeitsvolumen V2, in dem die Vorpolarisation der Probe P stattfindet, ein Feld, welches auf der z-Achse als Potenzreihe entwickelt werden kann:

$$BM(z) = H0M + H1M^*z + H2M^*z^2 + \ldots,$$

wobei z den axialen Abstand zum Zentrum des zweiten Arbeitsvolumens V2 bezeichnet. Die Entwicklungskoeffizienten HnM sind die Gradienten n-ter Ordnung des Feldes der Magnetanordnung M auf der z-Achse im zweiten Arbeitsvolumen V2. Die Magnetanordnung M soll in beiden Beispielen ein aktiv abgeschirmter 14.1 T Magnet sein, dessen Feld auf der z-Achse im zweiten Arbeitsvolumen V2 Gradienten der folgenden Stärke aufweist:

$$H0M = 0.388 \text{ T}$$

$$H1M = -5 \text{ T/m}$$

$$H2M = 30 \text{ T/m}^2$$

Die Schwerpunkte des ersten Arbeitsvolumens V1 und des zweiten Arbeitsvolumens V2 liegen in den vorliegenden Beispielen 450 mm auseinander. Die Gradienten höherer Ordnung H3M, H4M, ... können vernachlässigt werden.

Mit der Kompensationsanordnung m, m' aus weichmagnetischem Material soll das Feld im zweiten Arbeitsvolumen V2 soweit homogenisiert werden, dass darin eine starke DNP-Vorpolarisierung der Probe P möglich wird. Dies kann insbesondere  dadurch erreicht werden, dass die Gradienten H1 M und H2M kompensiert werden, ohne mit der Kompensationsanordnung m, m' zu große Gradienten höherer Ordnung zu erzeugen. In der Tabelle 1 sind die Daten der zwei Beispiele aus Fig. 4 und Fig. 6 aufgeführt. Die Kompensationsanordnungen sind bezüglich der z-Achse rotationssymmetrisch und umfassen jeweils drei Abschnitte A1, A1', A2, A2'; A3, A3' in Form von Hohlzylindern. Dabei bezeichnen ri jeweils die Innenradien und ra die Außenradien der Hohlzylinder, und zi sind die axialen Anfänge bzw. za die axialen Enden der Hohlzylinder, gemessen ab dem Zentrum des zweiten Arbeitsvolumens V2. Die Ausführung der Abschnitte als Hohlzylinder stellt eine besonders einfache Möglichkeit dar, eine erfindungsgemäße Kompensationsanordnung zu realisieren. Es ist jedoch auch möglich, eine Kompensationsanordnung vorzusehen, welche die z-Achse azimutal nicht vollständig umgibt, sondern bspw. aus einzelnen Segmenten besteht, die voneinander beabstandet sind.

Tabelle 1

|  | Beispiel 1 | Beispiel 2 |
|---|---|---|
| ri [mm] Hohlzylinder 1 | 21.50 | 35.00 |
| ra [mm] Hohlzylinder 1 | 26.00 | 45.05 |
| zi [mm] Hohlzylinder 1 | -33.72 | -60.94 |
| za [mm] Hohlzylinder 1 | -14.49 | -14.18 |
| ri [mm] Hohlzylinder 2 | 23.12 | 35.00 |
| ra [mm] Hohlzylinder 2 | 26.0 | 38.08 |
| zi [mm] Hohlzylinder 2 | -14.49 | -14.18 |
| za [mm] Hohlzylinder 2 | -1.75 | 0.62 |
| ri [mm] Hohlzylinder 3 | 24.20 | 35.00 |
| ra [mm] Hohlzylinder 3 | 26.00 | 39.07 |
| zi [mm] Hohlzylinder 3 | -1.75 | 0.62 |
| za [mm] Hohlzylinder 3 | 11.48 | 11.93 |
| Abbildung Geometrie | Figur 4 | Figur 6 |
| Feldprofil im zweiten Arbeitsvolumen | Figur 5 | Figur 7 |
| z Schwerpunkt [mm] | -15.18 | -31.88 |
| H0m [Tesla] | -0.0481 | -0.0478 |

Im Beispiel 1 (Fig. 4) haben alle Hohlzylinder einen gemeinsamen Außenradius ra. Das ist vorteilhaft, weil nach einer Feldmessung Korrekturfolien auf der Außenfläche mit einheitlichem Außenradius angebracht werden können, um die Feld-Homogenität im zweiten Arbeitsvolumen V2 weiter zu verbessern. Eine solche Kompensationsanordnung m könnte sich in der Raumtemperaturbohrung B eines Kryostaten K mit supraleitender Magnetanordnung M befinden, wie bspw. in Fig. 2 gezeigt. Die Wandstärke der Kompensationsanordnung m im Beispiel 1 nimmt ab mit zunehmendem z-Wert, also weiter entfernt von der Magnetanordnung M und vom ersten Arbeitsvolumen V1. Das Feld im zweiten Arbeitsvolumen V2 wird somit dadurch homogenisiert, dass das weichmagnetische Material näher an der Magnetanordnung M mehr Feld vernichtet, also dickwandiger ausgeführt wird, als in größerer Entfernung von der Magnetanordnung M, wo deren Streufeld schwächer ist.

Aus Beispiel 2 (Fig. 6) ist ersichtlich, dass diese Vorschrift für die Abhängigkeit der Wandstärke der Kompensationsanordnung m' vom Ort auf der z-Achse nicht in jeder Anordnung strikt erfüllt sein muss, sondern dass eine Kompensation auch möglich ist, wenn in einem kleinen Bereich mit zunehmendem Abstand vom ersten Arbeitsvolumen V1 die Wandstärke wieder zunimmt.

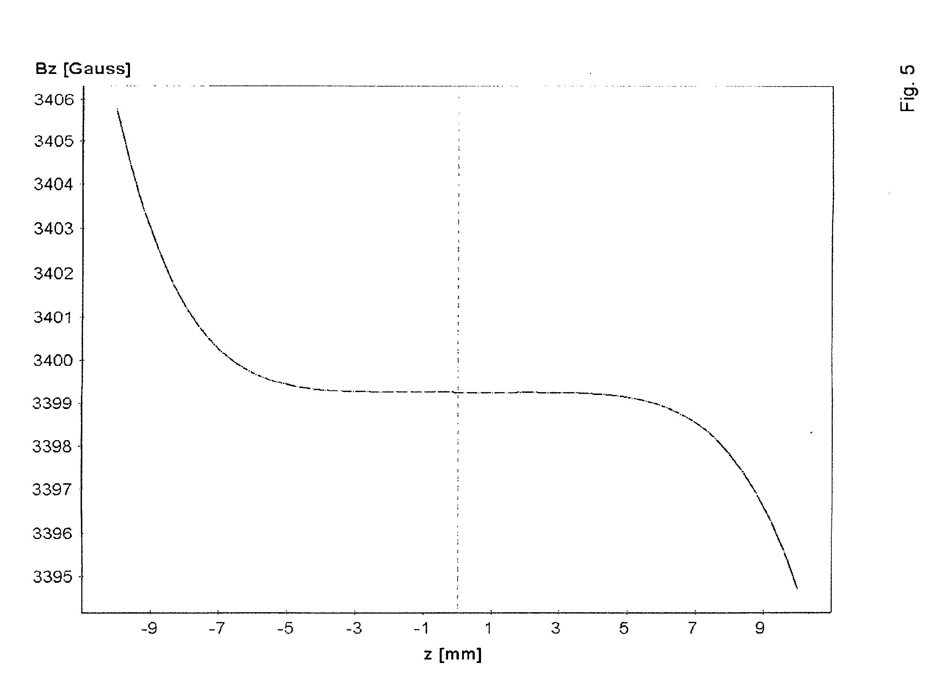

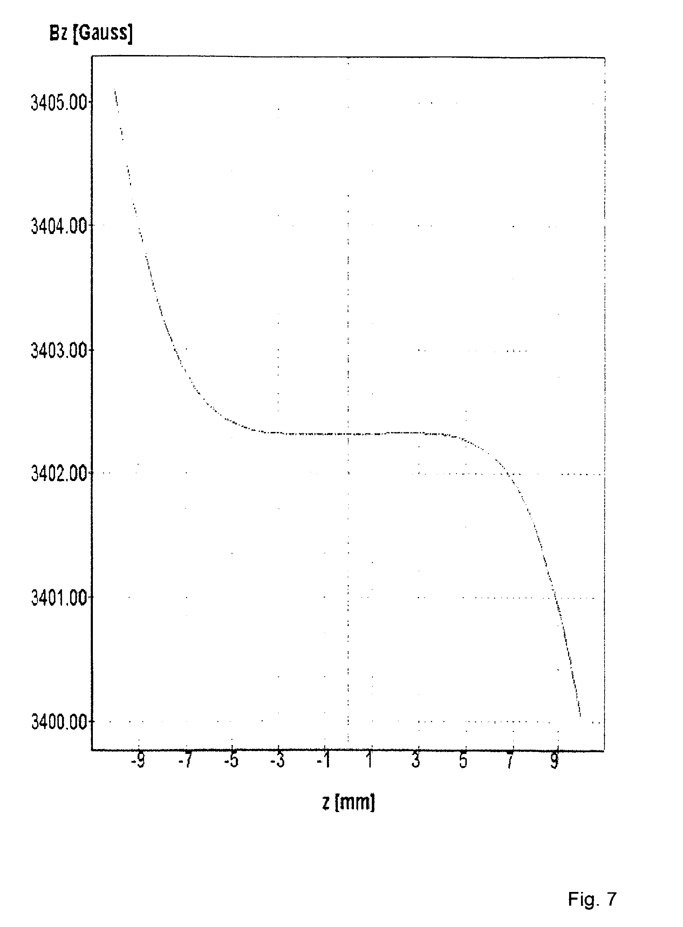

Schließlich sind in den Figuren 5 und 7 die Magnetfeldprofile dargestellt, welche sich als Überlagerung des Feldes der Magnetanordnung M und der jeweiligen Kompensationsanordnung m, m' ergibt. Man sieht, dass das Magnetfeld in Richtung des ersten Arbeitsvolumens V1, also bei negativen z-Werten, monoton zunimmt. Das ist in beiden Beispielen nicht nur lokal im zweiten Arbeitsvolumen V2, sondern entlang der z-Achse bis ins erste Arbeitsvolumen V1 hinein der Fall, weil in Richtung des ersten Arbeitsvolumens V1 das monoton stärker werdende Feld der Magnetanordnung M dasjenige der Kompensationsanordnung m, m' immer mehr dominiert. Somit wird die Probe P zwischen dem zweiten Arbeitsvolumen V2 und dem ersten Arbeitsvolumen V1 durch immer größere Felder transportiert, was die Beibehaltung ihrer im zweiten Arbeitsvolumen V2 erlangten Vorpolarisation begünstigt. Hier sei noch zu bemerken, dass Korrekturanordnungen m aus weichmagnetischem Material in der Regel etwas Feld vernichten, weshalb H0m in beiden Beispielen negativ ist.

Im Beispiel 2 (Fig. 6) haben alle Hohlzylinder einen gemeinsamen Innenradius. Der Vorteil einer solchen Ausführungsform ist, dass sich die Kompensationsanordnung m' im gleichen Behälter wie eine supraleitende Magnetanordnung M befinden kann. Mit dem möglichst klein gewählten, konstanten Innenradius ist die maximale Feldeffizienz der Kompensationsanordnung m' auch für diese Anordnungsweise gewährleistet.

Zur Auslegung der Kompensationsanordnungen m, m' der beiden Beispiele wurde davon ausgegangen, dass die Kompensationsanordnung m, m' aus weichmagnetischem Material besteht, das vom Streufeld der Magnetanordnung M in die magnetische Sättigung getrieben wird, was beim angenommenen Feldprofil der Magnetanordnung M mit den Gradienten HOM= 0.388 T, H1 M = -5 T/m und H2M = 30 T/m$^2$ eine zulässige Annahme ist. Die Magnetisierung der Kompensationsanordnung m, m' wurde zudem als parallel zur z-Achse angenommen, was im Wesentlichen der Richtung des Streufeldes der Magnetanordnung M im Volumen der Kompensationsanordnung m, m' entspricht. Für die magnetische Sättigung des weichmagnetischen Materials wurde eine für magnetischen Stahl typische Magnetisierung $M_m$ von 1.71*10$^6$ A/m angenommen.

Das Magnetfeld eines rein axial magnetisierten sich in der Sättigung befindenden Hohlzylinders mit Magnetisierung $M_m$ ist aufgrund der Feldgleichung

$$j = \text{rot } M_m$$

äquivalent zur Differenz der Magnetfelder von zwei Strombelägen mit Stromdichte $M_m$, wobei diese Strombeläge auf der Innen- bzw. Außenmantelfläche des Hohlzylinders liegen. Das Magnetfeld eines unendlich dünnen zylindrischen Strombelages mit Radius a und Länge 2L, welcher um z=0 zentriert und koaxial zur z-Achse ist, berechnet sich auf der z-Achse mit der Biot-Savart Formel zu

$$B_z(z) = \frac{\mu_0 M_m}{2}\left( \frac{z+L}{\sqrt{a^2 + (z+L)^2}} - \frac{z-L}{\sqrt{a^2 + (z-L)^2}} \right)$$

Das Feld eines um z=0 zentrierten, zur z-Achse koaxialen Hohlzylinders der Länge 2L mit Innenradius ri und Außenradius ra beträgt also

$$B_{z,Zyl}(z) = \frac{\mu_0 M_m}{2}\left( \frac{z+L}{\sqrt{ra^2 + (z+L)^2}} - \frac{z-L}{\sqrt{ra^2 + (z-L)^2}} \right) - \frac{\mu_0 M_m}{2}\left( \frac{z+L}{\sqrt{ri^2 + (z+L)^2}} - \frac{z-L}{\sqrt{ri^2 + (z-L)^2}} \right)$$

Das Feld eines um den Ort z=-z0 zentrierten, zur z-Achse koaxialen Hohlzylinders der Länge 2L mit Innenradius ri und Außenradius ra kann demnach in eine Potenzreihe

$$Bm(z) = H0m + H1m^*z + H2m^*z^2 + \ldots$$

um das Zentrum des zweiten Arbeitsvolumens V2 bei z=0 entwickelt werden, wobei die Entwicklungskoeffizienten (Gradienten) Hnm n-ter Ordnung die n-ten Ableitungen von $B_{z, zyl}(z)$ nach z am Ort z=z0 sind.

Falls eine Kompensationsanordnung m, m' mehrere koaxiale Hohlzylinder umfasst, ist der Gradient n-ter Ordnung der Gesamtanordnung jeweils die Summe der Gradienten n-ter Ordnung aller Teilzylinder.

Unter Verwendung der Potenzreihen-Entwicklungen der Kompensationsanordnung m, m' und jener des Feldes der Magnetanordnung M kann demnach für beide Beispiele das Gesamtfeld auf der z-Achse im zweiten Arbeitsvolumen geschrieben werden als:

$$B(z) = BM(z) + Bm(z) = (H0M + H0m) + (H1M + H1m)^*z + (H2M + H2m)^*z^2 + \ldots$$

Um im zweiten Arbeitsvolumen V2 eine für die DNP-Vorpolarisierung der Probe P ausreichende Feldhomogenität zu erzielen, wurde die Kompensationsanordnung m, m' in beiden Beispielen jeweils so dimensioniert, dass H1m = -H1M und H2m = -H2M ist. Die Überlagerung des Feldes der Magnetanordnung M und des Feldes der Kompensationsanordnung m, m' hat also keinen Term in z und in $z^2$. Die Kompensationsanordnung m, m' wurde zudem so ausgelegt, dass die Koeffizienten H3m und H4m so klein sind, dass sie im zweiten Arbeitsvolumen V2 keinen Einfluss auf das Feldprofil haben, was auch für den Feldbeitrag der Magnetanordnung M angenommen werden kann. Der dominante Term für das Feldprofil im zweiten Arbeitsvolumen V2 ist also in beiden Beispielen $H5m^*z^5$, so dass ein so genanntes $z^5$-Plateau entsteht, in dem die Vorpolarisation der Probe P stattfinden kann.

Da das Feld der Magnetanordnung M am Ort der Kompensationsanordnung m, m' inhomogen ist, wirkt zwischen beiden Anordnungen eine anziehende elektromagnetische Kraft, welche bei der Auslegung der Kompensationsanordnung m, m' zu beachten ist. Mit der Näherung der Potenzreihenentwicklung für das Feld der Magnetanordnung M im Volumen der Kompensationsanordnung m kann diese Kraft für die beiden Beispiele zu 230 bzw. 1650 Newton berechnet werden. Die Kompensationsanordnung m aus Beispiel 1 kann also beispielsweise ohne großen Aufwand aus der Bohrung B eines Kryostaten K einer supraleitenden Magnetanordnung M herausgezogen werden, ohne die Magnetanordnung M zu entladen.

Somit könnte das Anbringen von weichmagnetischen Korrekturfolien ohne großen Zeitverlust geschehen.

Kompensationsanordnungen m, m' können für aktiv abgeschirmte und für nichtabgeschirmte Magnetanordnungen vorgesehen werden. Sie sind für nichtabgeschirmte Magnetanordnungen einfacher auszulegen als in Zusammenwirkung mit einer aktiv abgeschirmten Magnetanordnung, weil die Feldabnahme zwischen dem ersten Arbeitsvolumen V1 und dem zweiten Arbeitsvolumen V2 weniger steil ist, so dass bei gleichem Feld H0M der Absolutwert des Feldgradienten H1M einer nicht abgeschirmten Magnetanordnung im zweiten Arbeitsvolumen V2 kleiner ist als bei einer aktiv abgeschirmten Magnetanordnung. Der Nachteil von nicht abgeschirmten Magnetanordnungen ist allerdings, dass der Abstand zwischen dem ersten Arbeitsvolumen V1 und dem zweiten Arbeitsvolumen V2 größer wird, so dass die Probe P mehr Zeit für den Transport benötigt. Während dieser Zeit kann ein Teil der Polarisation der Probe P verloren gehen.

Die Kompensationsanordnung m, m' kann zusätzlich zu den weichmagnetischen Teilen auch hartmagnetische umfassen. Außerdem kann die Kompensationsanordnung m, m' nicht axialsymmetrische Teile umfassen, oder solche, die sich nicht in der magnetischen Sättigung befinden oder nicht rein axial magnetisiert sind. Um die Feldgradienten Hnm solcher Anordnungen zu berechnen, müssen die genaue geometrische Anordnung der Komponenten und die Stärke und Richtung ihrer Magnetisierung berücksichtigt werden. Im Allgemeinen ist dies nur in Kenntnis der B-H-Kurven der entsprechenden Materialien sowie unter Anwendung von numerischen Methoden wie beispielsweise der Methode der Finiten Elemente möglich.

Wegen unvermeidlichen Produktionstoleranzen sowie wegen nicht ganz genau bekannten Materialeigenschaften der Kompensationsanordnung m, m' muss damit gerechnet werden, dass die Überlagerung der Feldprofile der Magnetanordnung M und der Kompensationsanordnung m, m' im zweiten Arbeitsvolumen V2 nicht exakt die gewünschte Homogenität aufweist. Mit der Anbringung von weichmagnetischen Folien auf der Kompensationsanordnung m, m' kann dann die Homogenität weiter verbessert werden.

Ferner kann eine weitere Spulenanordnung um das zweite Arbeitsvolumen V2 angebracht und so ausgelegt werden, dass sich damit Gradienten jeder gewünschten Ordnung korrigieren lassen können. Typische Geometrien für solche Spulenanordnungen sind z. B. aus der Patentschrift US7'330'031 bekannt.

Eine zusätzliche Möglichkeit, die Feld-Homogenität im zweiten Arbeitsvolumen V2 zu verbessern, bietet eine Vorrichtung, mit der die Kompensationsanordnung m, m' zusammen mit dem zweiten Arbeitsvolumen V2 entlang der z-Achse im Streufeld der Magnetanordnung M soweit verschoben werden kann, bis zumindest für eine Ordnung n der Gradienten der Magnetanordnung M und der Kompensationsanordnung m, m' gilt, das | HnM + Hnm | < 0.1 * | HnM |. Falls in der erfindungsgemäßen Anordnung der beiden Beispiele das gemessene Feldprofil der Überlagerung der Feldbeiträge der Kompensationsanordnung m, m' und der Magnetanordnung M einen Gradienten erster Ordnung aufweist, der beispielsweise um 0.1 T/m zu klein ist, dann kann die Kompensationsanordnung m, m' zusammen mit dem Arbeitsvolumen entlang der z-Achse an den Ort z' verschoben werden, an welchem der Gradient erster Ordnung der Magnetanordnung M um 0.1 T/m größer ist, also:

$$\left.\frac{dBM}{dz}\right|_{z'} = H1M + 2 \cdot H2M \cdot z' = H1M + 0.1\,{^T\!/_m}$$

Mit $H2M = 30$ T/m$^2$ ist demzufolge z' = 1.7 mm.

**Bezugszeichenliste**

| | |
|---|---|
| A1, A2, A3, A1', A2', A3' | Abschnitte der Kompensationsanordnung |
| B | Raumtemperaturbohrung des Kryostaten |
| D | Vorrichtung zur DNP Anregung |
| H1M, H2M, H3M,... | Magnetfeldgradienten des von der Magnetanordnung im zweiten Arbeitsvolumen erzeugten Streufelds |
| H1m, H2m, H3m, ... | Magnetfeldgradienten des von der Kompensationsanordnung im zweiten Arbeitsvolumen erzeugten Kompensationsfeldes |
| K | Kryostat |
| M | Magnetanordnung |
| m, m' | Kompensationsanordnung |
| N | Vorrichtung zur Messung von MR-Signalen |
| P | Probe |
| T | Transportmechanismus |
| V1 | erstes Arbeitsvolumen |
| V2 | zweites Arbeitsvolumen |
| z | Achse, welche durch das erste und das zweite Arbeitsvolumen verläuft |

**Patentansprüche**

1. Apparatur zur Durchführung von DNP- NMR Messungen an einer Probe (P), mit einer Magnetanordnung (M) zur Erzeugung eines Magnetfeldes in einem ersten Arbeitsvolumen (V1), wobei die Magnetanordnung (M) in einem zweiten Arbeitsvolumen (V2) ein Streufeld in Richtung einer Achse (z) mit mindestens einem Magnetfeldgradienten erster Ordnung (H1M) in Richtung der Achse (z) erzeugt, wobei die Achse (z) durch das zweite Arbeitsvolumen (V2) verläuft,

mit einer Vorrichtung (N) zum Messen von MR- Signalen der Probe (P) aus dem ersten Arbeitsvolumen (V1),

mit einer DNP- Anregungsvorrichtung (D) zur DNP- Anregung der Probe (P) im zweiten Arbeitsvolumen (V2) und

mit einer Positionierungseinrichtung (T) zum Transferieren der Probe (P) zwischen dem zweiten Arbeitsvolumen (V2) und dem ersten Arbeitsvolumen (V1),

**dadurch gekennzeichnet, dass**

beim zweiten Arbeitsvolumen (V2) eine Kompensationsanordnung (m) aus magnetischem Material angebracht ist, welche im Betriebszustand der Magnetanordnung (M) mindestens einen Magnetfeldgradienten erster Ordnung (H1 m) in Richtung der Achse (z) im zweiten Arbeitsvolumen (V2) erzeugt, der zwischen- 90% und- 110% des Magnetfeldgradienten gleicher Ordnung (H1M, H2M, ..., HnM) des Streufelds der Magnetanordnung (M) in Richtung der Achse (z) im zweiten Arbeitsvolumen (V2) beträgt.

2. Apparatur nach Anspruch 1, **dadurch gekennzeichnet, dass** die Kompensationsanordnung (m) weichmagnetische Abschnitte umfasst, welche im Betriebszustand der Magnetanordnung (M) vom Feld der Magnetanordnung (M) magnetisiert werden.

3. Apparatur nach Anspruch 2, **dadurch gekennzeichnet, dass** der Abstand zwischen dem Schwerpunkt des ersten Arbeitsvolumens (V1) und dem Schwerpunkt des zweiten Arbeitsvolumens (V2) größer ist als der Abstand zwischen dem Schwerpunkt des ersten Arbeitsvolumens (V1) und dem Schwerpunkt der Gesamtheit der weichmagnetischen Abschnitte.

4. Apparatur nach einem der vorherigen Ansprüche, **dadurch gekennzeichnet, dass** der Schwerpunkt des ersten Arbeitsvolumens (V1) und der Schwerpunkt des zweiten Arbeitsvolumens (V2) auf der Achse (z) liegen.

5. Apparatur nach einem der vorherigen Ansprüche, **dadurch gekennzeichnet, dass** die Magnetanordnung (M) mindestens teilweise supraleitend ist und sich mindestens teilweise in einem Kryostaten (K) befindet, der eine Bohrung (B) aufweist, in welcher das erste Arbeitsvolumen (V1) und das zweite Arbeitsvolumen (V2) angeordnet sind.

6. Apparatur nach Anspruch 5, **dadurch gekennzeichnet, dass** die Kompensationsanordnung (m) mindestens teilweise in der Bohrung (B) des Kryostaten (K) angeordnet ist.

7. Apparatur nach Anspruch 5, **dadurch gekennzeichnet, dass** die Kompensationsanordnung (m) außerhalb der Bohrung (B) des Kryostaten (K) angeordnet ist, insbesondere in einem Bereich des Kryostaten (K) mit einer Temperatur unterhalb der Raumtemperatur, vorzugsweise in einem Bereich des Kryostaten (K) mit der Betriebstemperatur der supraleitenden Teile der Magnetanordnung (M).

8. Apparatur nach einem der vorherigen Ansprüche, **dadurch gekennzeichnet, dass** eine weitere Spulenanordnung vorhanden ist, welche mit Strom gespeist werden kann und im zweiten Arbeitsvolumen (V2) einen homogenen Magnetfeldbeitrag (HOS) und/oder einen Magnetfeldgradienten (H1S, H2S, ... , HnS) erster oder höherer Ordnung in Richtung der Achse (z) erzeugt.

9. Apparatur nach Anspruch 8, **dadurch gekennzeichnet, dass** die weitere Spulenanordnung normalleitend ist.

10. Apparatur nach den Ansprüchen 5 und 9, **dadurch gekennzeichnet, dass** die weitere Spulenanordnung mindestens teilweise in der Bohrung (B) angeordnet ist.

11. Apparatur nach Anspruch 8, **dadurch gekennzeichnet, dass** die weitere Spulenanordnung supraleitend ist.

12. Apparatur nach einem der Ansprüche 1-6 oder 8-11, **dadurch gekennzeichnet, dass** zur Minimierung des Feldgradienten entlang der Achse im zweiten Arbeitsvolumen eine Vorrichtung zum Verschieben der Kompensationsanordnung (m) oder von Abschnitten der Kompensationsanordnung (m) und zum Verschieben des zweiten Arbeitsvolumens (V2) entlang der Achse (z) vorgesehen ist.

13. Verfahren zur Auslegung einer Kompensationsanordnung von magnetischem Material (m) in einer Apparatur nach einem der vorherigen Ansprüche, **dadurch gekennzeichnet,**

**dass** im zweiten Arbeitsvolumen (V2) in Richtung der Achse (z) mindestens eine Messung des Magnetfeldprofils durchgeführt wird, welches aus der Überlagerung des Feldbeitrages der Kompensationsanordnung (m) mit dem Feldbeitrag der Magnetanordnung (M) resultiert, und

**dass** aufgrund der Messung die Kompensationsanordnung (m) mindestens einmal dahingehend verändert wird, dass in der Überlagerung des Feldbeitrages der Kompensationsanordnung (m) mit dem Feldbeitrag der Magnetanordnung (M) der Absolutbetrag mindestens eines Magnetfeldgradienten (H1M+H1m) erster Ordnung in Richtung der Achse (z) im zweiten Arbeitsvolumen (V2) verkleinert wird.

14. Verfahren nach Anspruch 13, **dadurch gekennzeichnet, dass** der Verfahrensschritt der Veränderung der Kompensationsanordnung (m) die Anbringung oder Entfernung von magnetischem Material umfasst, insbesondere die Anbringung von magnetischen Folien.

15. Verfahren zur Positionierung der Kompensationsanordnung (m) und des zweiten Arbeitsvolumens (V2) in einer Apparatur nach Anspruch 12, **dadurch gekennzeichnet,**
**dass** im zweiten Arbeitsvolumen (V2) in Richtung der Achse (z) mindestens eine Messung des Magnetfeldprofils durchgeführt wird, welches aus der Überlagerung des Feldbeitrages der Kompensationsanordnung (m) mit dem Feldbeitrag der Magnetanordnung (M) resultiert, und
**dass** aufgrund der Messung die Kompensationsanordnung (m) oder Abschnitte der Kompensationsanordnung (m) zusammen mit dem zweiten Arbeitsvolumen (V2) entlang der Achse (z) verschoben werden, so dass in der Überlagerung des Feldbeitrages der Kompensationsanordnung (m) mit dem Feldbeitrag der Magnetanordnung (M) der Absolutbetrag mindestens eines Magnetfeldgradienten (H1M+H1m) erster Ordnung in Richtung der Achse (z) im zweiten Arbeitsvolumen (V2) verkleinert wird.

## Claims

1. Apparatus for carrying out DNP- NMR measurements on a sample (P), with a magnet configuration (M) for producing a magnetic field in a first working volume (V1), wherein the magnet configuration (M) produces a stray field in a second working volume (V2) in the direction of an axis (z) with at least one magnetic field gradient of first order (H1M) in the direction of the axis (z), wherein the axis (z) extends through the second working volume (V2), with a device (N) for measuring MR signals of the sample (P) from the first working volume (V1), with a DNP excitation device (D) for DNP excitation of the sample (P) in the second working volume (V2) and with a positioning mechanism (T) for transferring the sample (P) between the second working volume (V2) and the first working volume (V1), **characterized in that**, near the second working volume (V2), a compensation configuration (m) made of magnetic material is mounted that, in the operating mode of the magnet configuration (M), produces at least one magnetic field gradient of first order (H1m) in the direction of the axis (z) in the second working volume (V2) that is between- 90% and- 110% of the magnetic field gradient of the same order (H1M, H2M, ..., HnM) of the stray field of the magnet configuration (M) in the direction of the axis (z) in the second working volume (V2) .

2. Apparatus according to claim 1, **characterized in that** the compensation configuration (m) comprises magnetically soft sections that, in the operating mode of the magnet configuration (M), are magnetized by the field of the magnet configuration (M).

3. Apparatus according to claim 2, **characterized in that** the distance between the center of gravity of the first working volume (V1) and the center of gravity of the second working volume (V2) is greater than the distance between the center of gravity of the first working volume (V1) and the center of gravity of the totality of the magnetically soft sections.

4. Apparatus according to any one of the previous claims, **characterized in that** the center of gravity of the first working volume (V1) and the center of gravity of the second working volume (V2) are on the axis (z).

5. Apparatus according to any one of the previous claims, **characterized in that** the magnet configuration (M) is at least partially superconducting and is located at.least partially in a cryostat (K) that comprises a bore (B) in which the first working volume (V1) and the second working volume (V2) are disposed.

6. Apparatus according to claim 5, **characterized in that** the compensation configuration (m) is disposed at least partially in the bore (B) of the cryostat (K).

7. Apparatus according to claim 5, **characterized in that** the compensation configuration (m) is disposed outside the bore (B) of the cryostat (K), in particular, in a region of the cryostat (K) having a temperature below room temperature, preferably, in a region of the cryostat (K) having the operating temperature of the superconducting parts of the magnet configuration (M)

8. Apparatus according to any one of the previous claims, **characterized in that** a further coil configuration is present that can be supplied with electric current and produces, in the second working volume (V2), a homogeneous magnetic field contribution (HOS) and/or a magnetic field gradient (H1S, H2S, ..., HnS) of first or higher order in the direction of the axis (z).

9. Apparatus according to claim 8, **characterized in that** the further coil configuration is normally conducting.

10. Apparatus according to claims 5 and 9, **characterized in that** the further coil configuration is disposed at least partially in the bore (B).

11. Apparatus according to claim 8, **characterized in that** the further coil configuration is superconducting.

12. Apparatus according any one of the claims 1 to 6 or 8 to 11, **characterized in that** a device is provided for moving the compensation configuration (m) or sections of the compensation configuration (m) and for moving the second working volume (V2) along the axis (z) for minimizing the field gradient along the axis in the second working volume.

13. Method for designing a compensation configuration of magnetic material (m) in an apparatus according to any one of the previous claims, **characterized in that**,
in the second working volume (V2) in the direction of axis (z), at least one measurement is performed of the magnetic field profile that results from superposition of the field contribution of the compensation configuration (m) with the field contribution of the magnetic configuration (M), and
**in that**, based on the measurement, the compensation configuration (m) is changed at least once to ensure that, in the superposition of the field contribution of the compensation configuration (m) with the field contribution of the magnet configuration (M), the absolute value of at least one magnetic field gradient (H1M+H1m) of first order is reduced in the direction of the axis (z) in the second working volume (V2).

14. Method according to claim 13, **characterized in that** the step of the method for changing the compensation configuration (m) comprises the mounting or removal of magnetic material, in particular, the mounting of magnetic foils.

15. Method for positioning the compensation configuration (m) and the second working volume (V2) in an apparatus according to claim 12, **characterized in that**,
in the second working volume (V2) in the direction of the axis (z), at least one measurement is performed of the magnetic field profile that results from the superposition of the field contribution of the compensation configuration (m) with the field contribution of the magnet configuration (M), and
**in that**, based on the measurement, the compensation configuration (m) or sections of the compensation configuration (m) are moved along the axis (z) together with the second working volume (V2) so that, in the superposition of the field contribution of the compensation configuration (m) with the field contribution of the magnet configuration (M), the absolute value of at least one magnetic field gradient (H1M+H1m) of first order is reduced in the direction of the axis (z) in the second working volume (V2).

**Revendications**

1. Appareil pour effectuer des mesures DNP- RMN sur un échantillon (P), avec un agencement magnétique (M) pour générer un champ magnétique dans un premier volume de travail (V1), l'agencement magnétique (M) générant dans un deuxième volume de travail (V2) un champ de dispersion dans la direction d'un axe (z) avec au moins un gradient de champ magnétique de premier ordre (H1M) dans la direction de l'axe (z), l'axe (z) s'étendant à travers le deuxième volume de travail (V2),
avec un dispositif (N) pour mesurer les signaux RM de l'échantillon (P) provenant du premier volume de travail (V1),
avec un dispositif d'excitation DNP (D) pour l'excitation DNP de l'échantillon (P) dans le deuxième volume de travail (V2) et
avec un dispositif de positionnement (T) pour transférer l'échantillon (P) entre le deuxième volume de travail (V2) et le premier volume de travail (V1),
**caractérisé en ce**
**qu'**un dispositif de compensation (m) en matériau magnétique est placé au niveau du deuxième volume de travail (V2),
lequel génère, dans l'état de fonctionnement de l'agencement magnétique (M), au moins un gradient de champ magnétique de premier ordre (H1m) dans la direction de l'axe (z) dans le deuxième volume de travail (V2), qui est compris entre- 90 % et- 110 % du gradient de champ magnétique de même ordre (H1M, H2M, ..., HnM) du champ de dispersion de l'agencement magnétique (M) dans la direction de l'axe (z) dans le deuxième volume de travail (V2) .

2. Appareil selon la revendication 1, **caractérisé en ce que** le dispositif de compensation (m) comprend des parties magnétiques douces qui, dans l'état de fonctionnement de l'agencement magnétique (M), sont magnétisées par le champ de l'agencement magnétique (M).

3. Appareil selon la revendication 2, **caractérisé en ce que** la distance entre le centre de gravité du premier volume de travail (V1) et le centre de gravité du deuxième volume de travail (V2) est plus grande que la distance entre le centre de gravité du premier volume de travail (V1) et le centre de gravité de la totalité des parties magnétiques douces.

4. Appareil selon une des revendications précédentes, **caractérisé en ce que** le centre de gravité du premier volume de travail (V1) et le centre de gravité du deuxième volume de travail (V2) sont situés sur l'axe (z).

5. Appareil selon une des revendications précédentes, **caractérisé en ce que** l'agencement magnétique (M) est au moins partiellement supraconducteur et se trouve au moins partiellement dans un cryostat (K) qui présente un alésage (B) dans lequel le premier volume de travail (V1) et le deuxième volume de travail (V2) sont disposés.

6. Appareil selon la revendication 5, **caractérisé en ce que** le dispositif de compensation (m) est disposé au moins partiellement dans l'alésage (B) du cryostat (K).

7. Appareil selon la revendication 5, **caractérisé en ce que** le dispositif de compensation (m) est disposé à l'extérieur de l'alésage (B) du cryostat (K), en particulier dans une zone du cryostat (K) à une température inférieure à la température ambiante, de préférence dans une zone du cryostat (K) à la température de fonctionnement des parties supraconductrices de l'agencement magnétique (M).

8. Appareil selon une des revendications précédentes, **caractérisé en ce qu'**un autre agencement de bobines est présent, lequel peut être alimenté en courant et génère dans le deuxième volume de travail (V2) une contribution au champ magnétique homogène (HOS) et/ou un gradient de champ magnétique (H1S, H2S, ..., HnS) de premier ordre ou d'ordre supérieur dans la direction de l'axe (z).

9. Appareil selon la revendication 8, **caractérisé en ce que** l'autre agencement de bobines est normalement conducteur.

10. Appareil selon les revendications 5 et 9, **caractérisé en ce que** l'autre agencement de bobines est disposé au moins partiellement dans l'alésage (B).

11. Appareil selon la revendication 8, **caractérisé en ce que** l'autre agencement de bobines est supraconducteur.

12. Appareil selon une des revendications 1 à 6 ou 8 à 11, **caractérisé en ce que** pour minimiser le gradient de champ le long de l'axe dans le deuxième volume de travail, un dispositif pour déplacer le dispositif de compensation (m) ou des parties du dispositif de compensation (m) et pour déplacer le deuxième volume de travail (V2) le long de l'axe (z) est prévu.

13. Procédé de conception d'un dispositif de compensation de matériau magnétique (m) dans un appareil selon une des revendications précédentes, **caractérisé en ce qu'**au moins une mesure du profil de champ magnétique qui résulte de la superposition de la contribution au champ du dispositif de compensation (m) avec la contribution au champ de l'agencement magnétique (M) est effectuée dans le deuxième volume de travail (V2) dans la direction de l'axe (z), et
que sur la base de la mesure, le dispositif de compensation (m) est modifié au moins une fois de manière à diminuer, dans la superposition de la contribution au champ du dispositif de compensation (m) avec la contribution au champ de l'agencement magnétique (M), la valeur absolue d'au moins un gradient de champ magnétique (H1M+H1m) de premier ordre dans la direction de l'axe (z) dans le deuxième volume de travail (V2).

**14.** Procédé selon la revendication 13, **caractérisé en ce que** l'étape de modification du dispositif de compensation (m) comprend l'adjonction ou l'enlèvement de matériau magnétique, en particulier l'adjonction de feuilles magnétiques.

**15.** Procédé de positionnement du dispositif de compensation (m) et du deuxième volume de travail (V2) dans un appareil selon la revendication 12,
**caractérisé en ce**
**qu'**au moins une mesure du profil de champ magnétique qui résulte de la superposition de la contribution au champ du dispositif de compensation (m) avec la contribution au champ de l'agencement magnétique (M) est effectuée dans le deuxième volume de travail (V2) dans la direction de l'axe (z), et
**que** sur la base de la mesure, le dispositif de compensation (m) ou des parties du dispositif de compensation (m) sont déplacés ensemble avec le deuxième volume de travail (V2) le long de l'axe (z) de manière à diminuer, dans la superposition de la contribution au champ du dispositif de compensation (m) avec la contribution au champ de l'agencement magnétique (M), la valeur absolue d'au moins un gradient de champ magnétique (H1M+H1m) de premier ordre dans la direction de l'axe (z) dans le deuxième volume de travail (V2).

T

P

Z

D

Z=0

V₂

m

M

N

V₁

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005114244 A1
- WO 0237132 A1
- US 7330031 B